Europäisches Patentamt

(19) European Patent Office

Office européen des brevets

(11) Publication number : **0 506 537 A1**

(12) **EUROPEAN PATENT APPLICATION**

(21) Application number : 92400778.4

(22) Date of filing : 23.03.92

(51) Int. Cl.⁵ : **H01L 21/00, H02N 13/00**

(30) Priority : 28.03.91 JP 89745/91
29.03.91 JP 91234/91

(43) Date of publication of application :
**30.09.92 Bulletin 92/40**

(84) Designated Contracting States :
**DE FR GB**

(71) Applicant : **SHIN-ETSU CHEMICAL CO., LTD.**
**6-1, Ohtemachi 2-chome**
**Chiyoda-ku Tokyo (JP)**

(72) Inventor : Kubota, Yoshihiro
12-5, Kitakubo-machi
Takasaki-shi, Gunma-ken (JP)

Inventor : **Kawai, Makoto**
**787-2, Yanase**
**Annaka-shi, Gunma-ken (JP)**
Inventor : **Mogi, Hiroshi**
**2-11-22, Annaka**
**Annaka-shi, Gunma-ken (JP)**
Inventor : **Arai, Ken-ichi**
**1534-3, Shimonyuu**
**Toyooka-shi, Gunma-ken (JP)**
Inventor : **Kojima, Shinji**
**1816 Annaka**
**Annaka-shi, Gunma-ken (JP)**

(74) Representative : **Armengaud, Alain et al**
**Cabinet ARMENGAUD AINE 3, Avenue**
**Bugeaud**
**F-75116 Paris (FR)**

(54) **Electrostatic chuck.**

(57)    Proposed is an electrostatic chuck having an integral five-layered structure and useful in holding and transporting, for example, a semiconductor silicon wafer in the manufacturing process of electronic devices, which is advantageous in respect of the rapidness of the working behavior, in particular, in releasing the chucked body when the voltage applied to the electrodes is turned off. The electrostatic chuck comprises five layers including :

(a) a first electrically insulating dielectric layer ;

(b) an internal electrode layer formed on one surface of the first electrically insulating dielectric layer ;

(c) a second electrically insulating dielectric layer formed on the internal electrode layer ;

(d) an electroconductive layer formed on the second electrically insulating dielectric layer ; and

(e) a third electrically insulating dielectric layer formed on the electroconductive layer.

The present invention relates to an electrostatic chuck or, more particularly, relates to an electrostatic chuck used for holding and transporting, for example, a semiconductor silicon wafer, liquid crystal display panel or other articles under processing in the manufacturing process of electronic devices by means of the electrostatic attractive force.

It is a remarkable trend in recent years in the manufacturing process, in particular, of electronic devices such as semiconductor devices based on a silicon wafer, liquid crystal panels and the like that various processing steps such as etching, ion-implantation and the like are conducted under dry conditions since high productivity by automatization can be obtained by these dry processes as compared with traditional wet processes. One of the remarkable characteristics in these dry processes is that the treatment of the articles is performed in an atmosphere of high vacuum. Further, devices having a larger and larger size and finer and finer patterning with high precision are required for an increased density of circuit integration in the modern electronic industry.

Needless to say, the material under processing, e.g., semiconductor silicon wafers, glass substrate plates and the like, in such a processing treatment must be held or transported by some chucking means. One of the conventional chucking devices used for such a purpose is a vacuum chuck using a chucking plate having perforations and connected to an evacuation means so as to attract the substrate material by the sucking action. In principle, such a vacuum chuck cannot be used in a vacuum atmosphere because of the absence of any pressure difference between the surfaces of the work piece. Even as a chucking means used under normal pressure, vacuum chucks have a problem that the attractive force by sucking is localized on and around the perforations in the chucking plate so that a local strain is caused in the work piece under working as chucked thereby resulting in a decreased accuracy of alignment of the work piece for processing. Accordingly, vacuum chucks are considered not to be suitable for use in the manufacturing process of electronic devices due to this serious problem.

In place of the above mentioned vacuum chucks, electrostatic chucks, in which the work piece is held to the chucking plate by means of the electrostatic attractive force, are highlighted as a promising chucking means for holding and transporting various kinds of work pieces. Conventional electrostatic chucks typically have a structure in which metal electrodes connected to a direct-current power source are integrally embedded within a dielectric ceramic body at a depth near to the chucking surface or metal electrodes are sandwiched with two plates of a rubber or a synthetic resin such as polyimide as a dielectric material and they are integrally bonded together by use of an adhesive.

These conventional electrostatic chucks have a problem relative to the instantness of their working behavior, in particular, in releasing the attracted work piece by opening the circuit to the electrodes. Namely, the work piece attracted to and held by the chucking surface is sustainedly held thereon for a while after opening of the circuit to the electrodes of the electrostatic chuck due to the residual electrostatic charge therebetweem. This problem is particularly serious when the work piece is a silicon wafer having an electrically insulating surface layer of silicon oxide or a glass plate which itself is an insulating material because the electrostatic charge induced in these materials is poorly mobile in such an insulating material to prolongedly remain there even after circuit opening.

With an object to solve the above mentioned problem, Japanese Patent Kokai 62-94953 proposes use of an oxide of a relatively low electric resistance such as tin oxide, titanium oxide, lead titanate and the like as the dielectric material of the electrostatic chuck so as to rapidly decrease the residual electrostatic charge. Such an electrostatic chuck naturally has a disadvantage due to the decrease in the withstand voltage of the dielectric material so that, when the voltage applied to the electrodes is increased to obtain an increased attractive force, the performance of the chuck is sometimes damaged by the insulation breakdown to cause discharges or by the leak current along the surface of the dielectric material.

## SUMMARY OF THE INVENTION

The present invention accordingly has an object to provide a novel and improved electrostatic chuck free from the above described problems and disadvantages in the conventional electrostatic chucks in respect of the rapid working behavior in attracting and releasing the work pieces as well as high reliableness even with application of an increased voltage to the electrodes.

Thus, the electrostatic chuck of the invention is an integral body having a five-layered structure comprising successive five layers formed one on the other including:

(a) a first electrically insulating dielectric layer;
(b) an internal electrode layer formed on one surface of the first electrically insulating dielectric layer;
(c) a second electrically insulating dielectric layer formed on the internal electrode layer;
(d) an electroconductive layer formed on the second electrically insulating dielectric layer; and
(e) a third electrically insulating dielectric layer formed on the electroconductive layer.

In particular, one or more of the three dielectric layers are made preferably from an insulating ceramic material formed by sintering or formed by flame spraying.

## DETAILED DESCRIPTION OF THE PREFERRED EMBODIMENTS

As is described above, the electrostatic chuck of the invention has a unique five-layered structure consisting of successively formed five layers including a first dielectric layer which provides the chucking surface, an internal electrode layer, a second dielectric layer, an electroconductive layer and a third dielectric layer. Each of these three dielectric layers is preferably made from a ceramic material such as alumina, fused quartz glass, zirconium oxide, aluminum nitride, boron nitride, sialon and the like though not particularly limitative thereto.

The first dielectric layer, which is interposed between the internal electrode layer and the chucked work piece, should have a thickness in the range from 0.1 to 4.0 mm although this thickness should be as small as possible in respect of the attractive force which, in addition to the proportionality to the square of the voltage applied to the electrodes, is inversely proportional to the square of the distance between the electrodes and the chucked work piece. Namely, an increase in the attractive force by decreasing the thickness of the first dielectric layer can be achieved only at the sacrifice in respect of the difficulty in preparing such an extremely thin ceramic layer and the decrease in the mechanical strength of the layer. Needless to say, the attractive force of the chuck is decreased when the thickness of the first dielectric layer is too large.

The internal electrode layer on one surface of the first dielectric layer is made from a metal such as copper, aluminum, titanium, molybdenum, tungsten and the like. The thickness of this internal electrode layer is usually in the range from 5 to 200 μm though not particularly limitative. Accordingly, the internal electrode layer can be formed on the first dielectric layer by a suitable method depending on the desired thickness including, for example, printing with a conductive paste which is a pasty dispersion of fine metal particles in a suitable vehicle or by a dry process such as plasma spraying, sputtering and the like. The form or pattern of the electrodes depends on whether the electrostatic chuck is worked as a single-electrode chuck or as a double-electrode chuck. When the electrostatic chuck works with a single electrode, the counterelectrode being provided by the chucked work piece such as silicon wafer, namely, the internal electrode layer can be formed all over the surface of the first dielectric layer and provided with a lead wire to one of the terminals of the power source. When the electrostatic chuck works with a pair of two electrodes or, namely, it is of the double-electrode type, a typical, though not limitative, disposition of the two electrodes on the first dielectric layer, assuming a circular profile thereof, is that the metal layer formed on the surface of the first dielectric layer is divided into several concentrical ring-wise conductive zones of a suitable width each insulated from the adjacent zones by an insulating zone therebetween and the conductive zones are divided into two groups by connecting every second zone into one group, each group of the conductive zones being provided with a lead wire to one terminal of a direct-current power source to serve as an electrode.

The second insulating dielectric layer on the internal electrode layer can be made from a ceramic material of the same kind as the first dielectric layer and the thickness thereof is also in the range from 0.1 to 4.0 mm. The thickness should not be too large for the reason set forth below.

The electroconductive layer, which has an effect of accelerating decrease of the residual electrostatic charge when the power source is turned off, on the second dielectric layer can be made from a variety of conductive materials including carbon or graphite, certain electroconductive ceramics such as titanium nitride, zirconium boride and the like, and metals such as aluminum, titanium, copper, iron, nickel, molybdenum, tungsten and the like. This elctroconductive layer should have a thickness in the range from 5 to 100 μm in view of the workability in the laminating work. It is important that the distance of this electroconductive layer from the chucking surface, i.e. the exposed surface of the first dielectric layer, is not too large or not exceeding 8 mm or in the range from 0.2 mm to 8 mm by suitably selecting the thickness of each of the first and second dielectric layers and the internal electrode layer. When the distance is too large, the electroconductive layer is less effective in promoting the decrease of the residual charge. When the distance is too small or, for example, smaller than 0.2 mm, the dielectric layer or layers must be so thin accordingly sometimes to cause problems in the difficulty encoutered in the preparation thereof and insufficient insulation.

The third dielectric layer on the electroconductive layer, which can be made from a ceramic material of the same kind as the first and the second dielectric layers, serves as a base of the inventive chuck providing mechanical strengths and accuracy of the chucking surface to the functional part of the inventive electrostatic chuck consisting of the first and the second dielectric lay-ers, internal electrode layer and electroconductive layer. In this regard, the thickness of the third dielectric layer should be large enough in the range from 1 to 20 mm although some inconveniences are caused in mounting and handling of the chuck when the thickness thereof is too large.

The above described electrostatic chuck of the invention having the five-layered structure can be prepared by the methods described below, which, however, are given only for the purpose of illustration. Namely, green body sheets as a precursor of the three dielectric layers are formed by spreading a slip of the ceramic material in a thickness corresponding to the first to the third dielectric layers on a carrier sheet by using a doctor blade and the like followed by drying and the internal electrode layer and the electroconductive layer are provided on the surface of the green body sheets for the second and the third dielectric layers, respectively, for example, by screen printing with an electroconductive paste of a powder of a metal having a relatively high melting point such as molybdenum, tungsten and the like. Thereafter, the green body sheets are stacked one on the other and pressed together and then the stack is subjected to sintering by heating at a high temperature in a sintering furnace into an integral five-layered structure.

It is of course optional that, instead of the screen printing with a conductive paste, the internal electrode layer and the electroconductive layer are formed by other suitable methods such as electrolytic or electroless plating, flame spraying, sputtering and the like. For example, an electroconductive layer of aluminum can be formed by flame spraying on a ready-sintered ceramic sheet to serve as the second dielectric layer. Further, the dielectric layers of a ceramic material can also be sintered before being provided with the internal electrode layer or the electroconductive layer instead of forming these metallic layers on a green body sheet or the ceramic layer can be formed by flame spraying of a ceramic powder. For example, an electrode layer of a metal is formed by the flame spraying method on a sintered ceramic sheet as the first dielectric layer and then a ceramic layer to serve as the second dielectric layer is formed by the plasma-spraying method on the electrode layer followed by screen printing of the electroconductive layer with a conductive paste.

Following are the examples to illustrate the structure, preparation method and performance of the electrostatic chuck of the invention having a five-layered structure in more detail.

Example 1.

A ceramic slip was prepared by uniformly blending 100 parts by weight of a powder mixture consisting of 92% by weight of an aluminum nitride powder, 5% by weight of a yttrium oxide powder and 3% by weight of a calcium oxide powder, 10 parts by weight of a butyral resin, 50 parts by weight of trichloroethylene, 8 parts by weight of ethyl alcohol and 2 parts by weight of dioctyl phthalate and kneading the mixture in a ball mill for 40 hours followed by deaeration under reduced pressure to remove any bubbles therein along with evaporation of a small portion of the solvents. The slip thus prepared had a viscosity of 40,000 centipoise.

The ceramic slip was spread over a carrier film by using a doctor blade into a layer which had a thickness of 1 mm after drying into a green sheet, from which two disc sheets having a diameter of 180 mm were taken by cutting.

One of the 1 mm thick green disc sheets was provided by screen printing using a tungsten paste with a pair of electrodes each consisting of a group of concentric ring-wise zones each having a width of 2 mm and jointly forming an electrode with each of the ring-wise zones of the second group being interposed between two of the first group keeping an insulating zone of 2 mm width therebetween. The thus formed electrode layer had a thickness of 10 $\mu$m after drying of the paste.

Separately and in a similar manner to the above, a green body disc having a thickness of 5 mm and a diameter of 180 mm was prepared from the same ceramic slip. The 5 mm thick green disc body was provided over the whole surface with an electroconductive layer of molybdenum having a thickness of 10 $\mu$m as dried by screen printing using the same conductive paste of molybdenum in the same manner as above.

The 1 mm thick green disc sheet provided with the electrode layer as the second dielectric layer was placed on the electroconductive layer of the 5 mm thick green disc body as the third dielectric layer with the electrode layer facing upwardly and further the other 1 mm thick green disc sheet was mounted thereon as the first dielectric layer to provide the chucking surface. The thus stacked body was pressed at 100 °C under a pressure of 5 kg/cm$^2$ for 30 minutes into an integrated laminate, which was heated for 3 hours at a temperature of 1850 °C in an atmosphere of a gaseous mixture composed of 20% by volume of hydrogen and 80% by volume of nitrogen to effect sintering of the ceramic layers. The terminal areas of the internal electrode layer were double-plated first with nickel and then with gold and lead wires were bonded thereto by soldering to complete an electrostatic chuck.

A direct-current voltage of 1 kilovolt was applied between the lead wires to attract and hold a silicon wafer of 6 inch diameter and 0.6 mm thickness having a coating film of silicon dioxide and then the applied voltage was turned off so that the silicon wafer could be released without delay by virtue of the rapid decrease of the residual electrostatic charge.

Further, the silicon wafer attracted and held by the electrostatic chuck was subjected to a plasma etching treeatment of the silicon dioxide film thereon at 140 °C using carbon tetrafluoride gas and the etching rates on a number of points were measured to find that the variation in the etching rates was within ± 1.2% indicating excellent uniformity of the etching rate. The improvement in this regard presumably would be a consequence of the increased heat conduction by the presence of the electroconductive layer.

Comparative Example 1.

Another electrostatic chuck of the same dimensions as above was prepared in the same manner excepting omission of the electroconductive layer between the second and third dielectric layers. The result of the attracting and releasing test of a silicon wafer was that the silicon wafer could be released from the chcuk only after 35 seconds from the moment of turning off of the direct-current voltage. The variation in the etching rates in an etching test conducted in the same manner as in Example 1 was as large as ± 35%.

Example 2.

A disc of 95% pure alumina having a thickness of 15 mm and a diameter of 150 mm was provided on one surface all over with a layer of aluminum having a thickness of 50 $\mu$m by the plasma spraying method and further a layer of alumina having a thickness of 300 $\mu$m was formed thereon likewise by the plasma spraying method. A pair of comb-shaped electrodes of copper having a thickness of 40 $\mu$m at a distance of 1 mm from each other were formed by the plasma spraying method on the alumina layer. Finally, an alumina layer of 500 $\mu$m thickness was formed on the electrode layer of copper by the plasma spraying method to complete an electrostatic chuck after bonding two lead wires each to one of the electrodes.

The result of the attracting and releasing test of a silicon wafer of 6 inch diameter and 0.6 mm thickness was that the silicon wafer could be attracted immediately by applying a direct-current voltage of 1.5 kilovolts between the lead wires and released without delay by turning off the voltage.

Example 3.

Two green ceramic disc sheets having a thickness of 1 mm and a diameter of 150 mm were prepared in the same manner as in Example 1 from a ceramic slip having a viscosity of 38,000 centipoise prepared by uniformly blending 100 parts by weight of a powder mixture consisting of 95% by weight of an aluminum nitride powder and 5% by weight of a yttrium oxide powder, 8 parts by weight of a butyral resin, 50 parts by weight of trichloroethylene, 10 parts by weight of ethyl alcohol and 2 parts by weight of dioctyl phthalate and kneading the mixture in a ball mill for 35 hours followed by deaeration under reduced pressure to remove any bubbles therein along with evaporation of a small portion of the solvents.

One of the green disc sheets was provided by screen printing with a tungsten paste to form a pair of electrodes having a thickness of 10 $\mu$m each consisting of a group of concentric ring-wise zones of 1 mm width as in Example 1. The other green disc sheet was put on the printed surface of the first green disc sheet and they were pressed to give an integrated laminate body which was subjected to a heat treatment for 2 hours at a temperature of 1880 °C in an atmosphere of a gaseous mixture of 20% by volume of hydrogen and 80% by volume of nitrogen into a sintered laminate body. An electroconductive layer of aluminum having a thickness of 150 $\mu$m was formed on one surface of the sintered laminate body all over by the plasma spraying method. Further, a sintered disc of aluminum nitride having a thickness of 10 mm and a diameter of 150 mm was put on the thus formed electroconductive layer and they were heated at 700 °C for 60 minutes so as to bond the aluminum nitride disc to the electroconductive layer of aluminum. An electrostatic chuck was completed by connecting two lead wires each to one of the electrodes in the same manner as in Example 1.

The attracting and releasing test of a silicon wafer was undertaken in the same manner as in Example 1 using a silicon wafer having a diameter of 6 inches and a thickness of 0.6 mm. The result was that the silicon wafer attracted and held by the chuck could be released without delay when the voltage applied to the electrodes was turned off.

For comparison, another electrostatic chuck of the same dimensions as above was prepared in the same manner excepting omission of the electroconductive layer of aluminum. The result of the attracting and releasing test of a silicon wafer by using this comparative chuck was that the silicon wafer attracted and held by the chuck could be released only after 12 seconds from the moment of turning off of the voltage applied to the electrodes.

Example 4.

A sintered alumina disc sheet having a thickness of 0.8 mm and a diameter of 200 mm was provided with a pair of electrodes in the same pattern as in Example 3 by plating with nickel in a thickness of 2 $\mu$m. A layer of alumina having a thickness of 0.5 mm was formed on the electrode layer of nickel by the plasma spraying method of an alumina powder and further an electroconductive layer having a thickness of 145 $\mu$m was formed thereon all over the whole surface by screen printing with a mixed paste of titanium and copper in a weight ratio of 25:75. A sintered disc of alumina having a thickness of 15 mm and a diameter of 200 mm was put on the thus formed electroconductive layer and they were bonded by heating at 1100 °C in vacuum. An electrostatic chuck was completed by connecting two lead wires each to one of the electrodes in the same manner as in Example 1.

The attracting and releasing test of a silicon wafer was undertaken in the same manner as in Example 1 using a silicon wafer having a diameter of 8 inches and a thickness of 0.6 mm. The result was that the silicon wafer attracted and held by the chuck could be released without delay when the voltage applied to the electrodes was turned off.

## Claims

1. An electrostatic chuck which is an integral body having a five-layered structure comprising successive five layers formed one on the other including:
   (a) a first electrically insulating dielectric layer;
   (b) an internal electrode layer formed on one surface of the first electrically insulating dielectric layer;
   (c) a second electrically insulating dielectric layer formed on the internal electrode layer;
   (d) an electroconductive layer formed on the second electrically insulating dielectric layer; and
   (e) a third electrically insulating dielectric layer formed on the electroconductive layer.

2. The electrostatic chuck as claimed in claim 1 in which each of the first to third electrically insulating dielectric layers is made from a ceramic material.

3. The electrostatic chuck as claimed in claim 1 in which the first electrically insulating dielectric layer has a thickness in the range from 0.1 to 4.0 mm.

4. The electrostatic chuck as claimed in claim 1 in which the second electrically insulating dielectric layer has a thickness in the range from 0.1 to 4.0 mm.

5. The electrostatic chuck as claimed in claim 1 in which the third electrically insulating dielectric layer has a thickness in the range from 1 to 20 mm.

6. The electrostatic chuck as claimed in claim 1 in which the internal electrode layer has a thickness in the range from 5 to 200 $\mu$m.

7. The electrostatic chuck as claimed in claim 1 in which the electroconductive layer has a thickness in the range from 5 to 100 $\mu$m.

8. A method for the preparation of an electrostatic chuck which is an integral body having a five-layered structure comprising successive five layers formed one on the other including:
   (a) a first electrically insulating dielectric layer;
   (b) an internal electrode layer formed on one surface of the first electrically insulating dielectric layer;
   (c) a second electrically insulating dielectric layer formed on the internal electrode layer;
   (d) an electroconductive layer formed on the second electrically insulating dielectric layer; and
   (e) a third electrically insulating dielectric layer formed on the electroconductive layer, of which each of the first to third electrically insulating dielectric layers is made from a ceramic material, which method comprises the steps of:
   (A) stacking three sheets of green body of the ceramic matefrial one on the other by sandwiching an internal electrode layer between the first and the second sheets and an electroconductive layer between the second and the third sheets;
   (B) pressing the sheets into an integral laminate body; and
   (C) heating the integral laminate body to effect sintering of the ceramic material.

9. A method for the preparation of an electrostatic chuck which is an integral body having a five-layered structure comprising successive five layers formed one on the other including:
   (a) a first electrically insulating dielectric layer;
   (b) an internal electrode layer formed on one surface of the first electrically insulating dielectric layer;
   (c) a second electrically insulating dielectric layer formed on the internal electrode layer;
   (d) an electroconductive layer formed on the second electrically insulating dielectric layer; and
   (e) a third electrically insulating dielectric layer formed on the electroconductive layer,
of which each of the first to third electrically insulating dielectric layers is made from a ceramic material, which method comprises the steps of:
   (A) forming an internal electrode layer on a first green ceramic sheet;
   (B) putting a second green ceramic sheet on the internal electrode layer to give a stack;
   (C) heating the stack to effect sintering of the green ceramic sheets into an integral laminate;
   (D) forming an electroconductive layer on one of the surfaces of the integral laminate; and
   (E) bonding a sintered ceramic sheet to the electroconductive layer.

10. A method for the preparation of an electrostatic chuck which is an integral body having a five-layered structure comprising successive five layers formed one on the other including:
   (a) a first electrically insulating dielectric layer;

(b) an internal electrode layer formed on one surface of the first electrically insulating dielectric layer;

(c) a second electrically insulating dielectric layer formed on the internal electrode layer;

(d) an electroconductive layer formed on the second electrically insulating dielectric layer; and

(e) a third electrically insulating dielectric layer formed on the electroconductive layer,

of which each of the first to third electrically insulating dielectric layers is made from a ceramic material, which method comprises the steps of:

(A) forming an internal electrode layer on a first sintered ceramic sheet;

(B) forming a second sintered ceramic sheet on the internal electrolde layer by the plasma spraying method to give an integral laminate;

(C) forming an electroconductive layer on one of the surfaces of the integral laminate; and

(D) bonding a sintered ceramic sheet as the third electrically insulating dielectric layer to the electroconductive layer.

**European Patent Office**

## EUROPEAN SEARCH REPORT

Application Number

EP 92 40 0778

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X<br>A | EP-A-0 360 529 (TOTO)<br>* column 2, line 43 - column 3, line 13; figure 1 *<br>--- | 1,3,4<br>2,8 | H01L21/00<br>H02N13/00 |
| A | PATENT ABSTRACTS OF JAPAN<br>vol. 012, no. 184 (E-614)28 May 1988<br>& JP-A-62 286 248 ( TOTO ) 12 December 1987<br>* abstract *<br>----- | 1,9,10 | |
| | | | **TECHNICAL FIELDS SEARCHED (Int. Cl.5)**<br><br>H01L<br>H02N |

The present search report has been drawn up for all claims

| Place of search | Date of completion of the search | Examiner |
|---|---|---|
| THE HAGUE | 09 JULY 1992 | BOLDER G.J.A. |

EPO FORM 1503 03.82 (P0401)